(19) Europäisches Patentamt
European Patent Office
Office européen des brevets

(11) **EP 2 071 591 A1**

(12) **EUROPEAN PATENT APPLICATION**
published in accordance with Art. 153(4) EPC

(43) Date of publication:
**17.06.2009 Bulletin 2009/25**

(51) Int Cl.:
*H01B 13/00* (2006.01)     *C08J 7/00* (2006.01)
*H01L 21/306* (2006.01)

(21) Application number: **07807213.9**

(22) Date of filing: **13.09.2007**

(86) International application number:
**PCT/JP2007/067806**

(87) International publication number:
**WO 2008/041461 (10.04.2008 Gazette 2008/15)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **29.09.2006 JP 2006268663**
**29.09.2006 JP 2006268694**
**29.09.2006 JP 2006268737**
**07.11.2006 JP 2006301212**

(71) Applicants:
• **Tsurumi Soda Co, Ltd.**
**Tsurumi-ku, Yokohama-shi**
**Kanagawa 230-0045 (JP)**

• **TOAGOSEI CO., LTD.**
**Minato-ku**
**Tokyo 105-8419 (JP)**

(72) Inventors:
• **IHARA, Takashi**
**Nagoya-shi, Aichi 455-0026 (JP)**
• **FUJIMOTO, Takahiro**
**Tokyo 105-8419 (JP)**

(74) Representative: **Wilhelms · Kilian & Partner**
**Patentanwälte**
**Eduard-Schmid-Strasse 2**
**81541 München (DE)**

(54) **ETCHING LIQUID FOR CONDUCTIVE POLYMER AND METHOD FOR PATTERNING CONDUCTIVE POLYMER**

(57)    The object is to provide an etching liquid for a conductive polymer having excellent etching capability toward a conductive polymer, and a method for patterning a conductive polymer employing the etching liquid for a conductive polymer. The conductive etching liquid of the present invention is selected from the group consisting of (1) an etching liquid comprising greater than 0.5 wt % but no greater than 70 wt % of $(NH_4)_2Ce(NO_3)_6$ or at least 0.5 wt % but no greater than 30 wt % of $Ce(SO_4)_2$, (2) an etching liquid comprising greater than 0.5 wt % but no greater than 30 wt % of $(NH_4)_4Ce(SO_4)_4$, (3) an etching liquid comprising a hypochlorous acid salt aqueous solution having an effective chlorine concentration of at least 0.06 wt % and a pH of greater than 3 but less than 8, (4) an etching liquid comprising nitrosyl chloride which comprises at least 5 wt % of hydrochloric acid and at least 20 wt % of nitric acid, a (hydrochloric acid concentration + 0.51 x nitric acid concentration) value being no greater than 35 wt %, and a (hydrochloric acid concentration + 0.5 x nitric acid concentration) value being at least 30 wt %, (5) an etching liquid comprising at least 3 wt % but no greater than 40 wt % of a bromic acid compound and at least 4 wt % of an inorganic acid, (6) an etching liquid comprising at least 6 wt % but no greater than 40 wt % of a chloric acid compound and at least 7 wt % of a hydrogen halide, (7) an etching liquid comprising at least 0.001 wt % but no greater than 20 wt % of a permanganic acid compound, and (8) an etching liquid comprising at least 3 wt % but no greater than 30 wt % of a hexavalent chromium compound.

*FIG.1*

**Description**

The present invention relates to an etching liquid for a conductive polymer, and a method for patterning a conductive polymer.

Currently, as a transparent conductive film, it is mainly ITO (indium tin oxide), which contains indium (In), that is used, but In is a rare element with recoverable reserves of 3,000 tons. It is predicted that the recoverable reserves might be exhausted as early as around 2011 to 2013, and alternative materials to ITO that do not employ In have been investigated. There have been remarkable improvements in the conductivity of conductive polymers, and conductive polymers are promising as alternative materials to ITO.

These conductive polymers have the characteristics of being electrically conductive, optically transmissive, luminescent, and flexible even after being made into a film; the application thereof to transparent conductive films, electrolytic capacitors, antistatic agents, batteries, organic EL elements, etc. has been investigated, and in some areas they are finding practical use.

By using a conductive polymer having high stability and higher conductivity than the electrolyte of an electrolytic capacitor, an electrolytic capacitor having improved frequency characteristics and excellent heat resistance can be formed.

Since static electricity can be prevented while maintaining transparency by forming a thin film of a conductive polymer on the surface of a polymer film, such a conductive polymer is used as an antistatic film or an antistatic container having good ease of use.

Conductive polymers can be used as the positive electrode of a rechargeable buttery, and are used in a lithium polyaniline cell, a lithium ion polymer cell, etc.

Furthermore, there are polymer organic EL displays in which a conductive polymer is used as a light-emitting layer, and flexible displays can be formed by using plastic as a substrate instead of glass. Moreover, positive hole-transporting layers may employ a conductive polymer. Organic EL displays such as polymer organic EL displays have a wide viewing angle because they are self-luminous displays, can easily be made thin, and have excellent color reproduction. Furthermore, since luminescence is due to recombination of a positive hole and an electron, the response speed is high. As hereinbefore described, since organic EL displays have excellent features, they have future promise as displays.

Furthermore, electronic elements such as diodes and transistors may be formed by using a conductive polymer, and improvements in performance are being investigated. In order to develop a solar cell that is less expensive than the currently predominant solar cells employing silicon, the use of a conductive polymer instead of platinum as a counter electrode to titanium dioxide in a dye-sensitized solar cell has been investigated.

In this way, conductive polymers are useful materials for the electronics industry in the future, and a method for patterning a conductive polymer is an important technique when a conductive polymer is used.

There are several types of methods for patterning a conductive polymer. First, there is patterning employing a printing method such as inkjet (see e.g. Patent Publication 1). Since the printing method carries out patterning at the same time as film formation, the production process is simple, but it is necessary to make a conductive polymer into an ink. However, conductive polymers are prone to aggregation, and it is difficult to make them into an ink. Furthermore, it is necessary to prevent spreading after printing, and there is the problem that a peripheral area of a liquid droplet becomes thicker than a central area after the ink dries.

On the other hand, a photoetching method, which is widely used for patterning, carries out patterning after a uniform film is formed, and there is therefore an advantage that a simple film-forming method can be employed.

Methods for patterning a conductive polymer by etching are disclosed, for example, in Patent Publication 2 and Patent Publication 3.

However, Patent Publication 2 does not describe an etching liquid used in etching of a conductive polymer.

Patent Publication 3 discloses carrying out etching of polypyrrole (PPy) as a conductive polymer using a hypochlorous acid salt, $(NH_4)_2Ce(SO_4)_3$, etc. The hypochlorous acid salt that is used here is a commercial bleach (Clorox (product name) bleach), but an aqueous solution thereof is alkaline and there is the problem that a photoresist, which is indispensable to etching, is damaged. An example in which $(NH_4)_2Ce(SO_4)_3$ was used is also described.

Furthermore, Patent Publication 3 discloses a method for patterning, without etching, by contacting an area that has not been covered by a photoresist with a chemical solution (e.g. tetramethylammonium hydroxide (TMAH) or $NH_4OH$) to thus increase the electrical resistance, or with another chemical solution (e.g. HCl, $HNO_3$, $HClO_4$, and $H_2SO_4$) so as to reduce the electrical resistance. However, in accordance with such a method for patterning by increasing or reducing the electrical resistance, insulation is not sufficient and it is not practical. In particular, insulation between elements is important for application in a display such as an organic EL display.

(Patent Publication 1) JP-A-2005-109435 (JP-A denotes a Japanese unexamined patent application publication)
(Patent Publication 2) JP-A-5-335718

(Patent Publication 3) WO97/18944

It is an object of the present invention to provide an etching liquid for a conductive polymer, the etching liquid having excellent etching capability toward a conductive polymer, and a method for patterning a conductive polymer employing the etching liquid for a conductive polymer.

As a result of an intensive investigation by the present inventors in order to solve the problems of the above-mentioned conventional techniques, it has been found the above-mentioned object can be attained by <1> and <13> below, and the present invention has thus been accomplished. They are described together with <2> to <12>, which are preferred embodiments.

<1> An etching liquid for a conductive polymer selected from the group consisting of (1) an etching liquid comprising greater than 0.5 wt % but no greater than 70 wt % of $(NH_4)_2Ce(NO_3)_6$ or at least 0.5 wt % but no greater than 30 wt % of $Ce(SO_4)_2$, (2) an etching liquid comprising greater than 0.5 wt % but no greater than 30 wt % of $(NH_4)_4Ce(SO_4)_4$, (3) an etching liquid comprising a hypochlorous acid salt aqueous solution having an effective chlorine concentration of at least 0.06 wt % and a pH of greater than 3 but less than 8, (4) an etching liquid comprising nitrosyl chloride which comprises at least 5 wt % of hydrochloric acid and at least 20 wt % of nitric acid, a (hydrochloric acid concentration + 0.51 x nitric acid concentration) value being no greater than 35 wt %, and a (hydrochloric acid concentration + 0.5 x nitric acid concentration) value being at least 30 wt %, (5) an etching liquid comprising at least 3 wt % but no greater than 40 wt % of a bromic acid compound and at least 4 wt % of an inorganic acid, (6) an etching liquid comprising at least 6 wt % but no greater than 40 wt % of a chloric acid compound and at least 7 wt % of a hydrogen halide, (7) an etching liquid comprising at least 0.001 wt % but no greater than 20 wt % of a permanganic acid compound, and (8) an etching liquid comprising at least 3 wt % but no greater than 30 wt % of a hexavalent chromium compound,

<2> the etching liquid for a conductive polymer according to <1>, wherein the etching liquid (1) comprises $(NH_4)_2Ce(NO_3)_6$ and greater than 0.1 wt % but no greater than 70 wt % of nitric acid,

<3> the etching liquid for a conductive polymer according to <1>, wherein the etching liquid (1) comprises $(NH_4)_2Ce(NO_3)_6$ and greater than 0.1 wt % but no greater than 60 wt % of $HClO_4$,

<4> the etching liquid for a conductive polymer according to <1>, wherein the etching liquid (1) comprises $Ce(SO_4)_2$ and greater than 0.1 wt % but no greater than 70 wt % of nitric acid,

<5> the etching liquid for a conductive polymer according to <1>, wherein the etching liquid (1) comprises $Ce(SO_4)_2$ and greater than 0.1 wt % but no greater than 40 wt % of sulfuric acid,

<6> the etching liquid for a conductive polymer according to <1>, wherein the etching liquid (2) comprises greater than 1 wt % but no greater than 40 wt % of sulfuric acid,

<7> the etching liquid for a conductive polymer according to <1>, wherein in the etching liquid (3), the hypochlorous acid salt aqueous solution is a hypochlorous acid alkali metal salt aqueous solution,

<8> the etching liquid for a conductive polymer according to <1>, wherein the etching liquid (7) comprises 1 to 50 wt % of an acid,

<9> the etching liquid for a conductive polymer according to any one of <1> to <8>, wherein the conductive polymer is a polyacetylene, a polyparaphenylene, a poly(paraphenylene vinylene), a polyphenylene, a poly(thienylene vinylene), a polyfluorene, a polyacene, a polyaniline, a polypyrrole, or a polythiophene,

<10> the etching liquid for a conductive polymer according to any one of <1> to <8>, wherein the conductive polymer is a polyaniline, a polypyrrole, or a polythiophene,

<11> the etching liquid for a conductive polymer according to any one of <1> to <8>, wherein the conductive polymer is a polyaniline or a polythiophene,

<12> the etching liquid for a conductive polymer according to any one of <1> to <8>, wherein the conductive polymer is poly(3,4-ethylenedioxythiophene),

<13> a method for patterning a conductive polymer employing the etching liquid for a conductive polymer according to any one of <1> to <8>.

In accordance with the present invention, there can be provided an etching liquid for a conductive polymer, the etching liquid having excellent etching capability toward a conductive polymer, and a method for patterning a conductive polymer employing the etching liquid for a conductive polymer.

Brief Description of Drawings

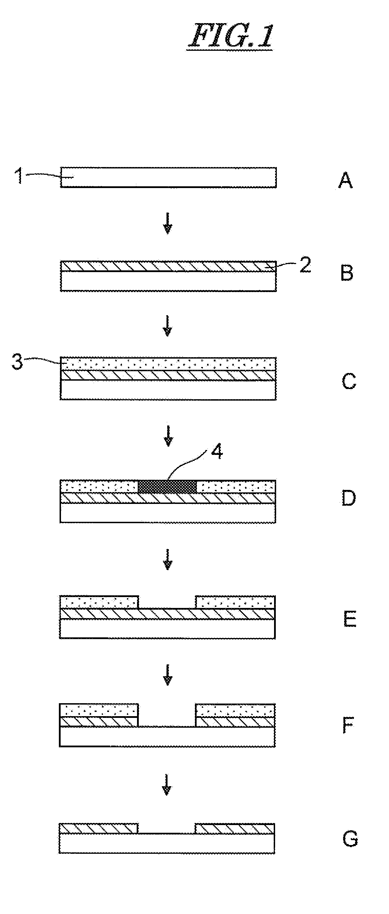

(FIG. 1) One example of a schematic process drawing for obtaining a circuit pattern of a conductive polymer by etching a conductive polymer using the etching liquid of the present invention.

Explanation of Reference Numerals and Symbols

A    A schematic diagram of a transparent substrate on its own.
B    A schematic diagram of the transparent substrate on which a conductive polymer film is mounted.
C    A schematic diagram of the conductive polymer film coated with a resist.
D    A schematic diagram of the resist exposed according to a circuit pattern.
E    A schematic diagram after the exposed resist is removed.
F    A schematic diagram after the conductive polymer film is etched using the etching liquid of the present invention.
G    A schematic diagram in which the resist is removed and a circuit diagram employing the conductive polymer is completed.
1    Transparent substrate
2    Conductive polymer film
3    Resist
4    Exposed resist

The etching liquid for a conductive polymer (hereinafter, also simply called an 'etching liquid') of the present invention is selected from the group consisting of

(1) an etching liquid comprising greater than 0.5 wt % but no greater than 70 wt % of $(NH_4)_2Ce(NO_3)_6$ or at least 0.5 wt % but no greater than 30 wt % of $Ce(SO_4)_2$,
(2) an etching liquid comprising greater than 0.5 wt % but no greater than 30 wt % of $(NH_4)_4Ce(SO_4)_4$,
(3) an etching liquid comprising a hypochlorous acid salt aqueous solution having an effective chlorine concentration of at least 0.06 wt % and a pH of greater than 3 but less than 8,
(4) an etching liquid comprising at least 5 wt % of hydrochloric acid, at least 20 wt % of nitric acid, a (hydrochloric acid concentration + 0.51 x nitric acid concentration) value being no greater than 35 wt % and a (hydrochloric acid concentration + 0.5 x nitric acid concentration) value being at least 30 wt %, and nitrosyl chloride,
(5) an etching liquid comprising at least 3 wt % but no greater than 40 wt % of a bromic acid compound and at least 4 wt % of an inorganic acid,
(6) an etching liquid comprising at least 6 wt % but no greater than 40 wt % of a chloric acid compound and at least 7 wt % of a hydrogen halide,
(7) an etching liquid comprising at least 0.001 wt % but no greater than 20 wt % of a permanganic acid compound, and
(8) an etching liquid comprising at least 3 wt % but no greater than 30 wt % of a hexavalent chromium compound.

Furthermore, the method for patterning a conductive polymer (hereinafter, also simply called a 'patterning method') of the present invention is a method employing the etching liquid for a conductive polymer of the present invention.
The present invention is explained in detail below. Unless otherwise specified, '%' denotes 'wt %'.
The etching liquids shown in (1) to (8) above are explained.
(1) Etching liquid comprising greater than 0.5 wt % but no greater than 70 wt % of $(NH_4)_2Ce(NO_3)_6$ or at least 0.5 wt % but no greater than 30 wt % of $Ce(SO_4)_2$
The first etching liquid of the present invention is an etching liquid comprising greater than 0.5 wt % but no greater than 70 wt % of $(NH_4)_2Ce(NO_3)_6$, at least 0.5 wt % but no greater than 30 wt % of $Ce(SO_4)_2$, or at least 0.5 wt % but no greater than 30 wt % of $Ce(NO_3)_4$, and preferably comprising greater than 0.5 wt % but no greater than 70 wt % of $(NH_4)_2Ce(NO_3)_6$ or at least 0.5 wt % but no greater than 30 wt % of $Ce(SO_4)_2$.
As the etching liquid of the present invention, $(NH_4)_2Ce(NO_3)_6$, $Ce(SO_4)_2$, or $Ce(NO_3)_4$ may be used, and it is preferable to use $(NH_4)_2Ce(NO_3)_6$ or $Ce(SO_4)_2$. These cerium (IV) salts may be hydrates. In the present invention, $(NH_4)_2Ce(NO_3)_6$ is yet more preferable since a conductive polymer can be etched in a short period of time.
A solvent of the etching liquid of the present invention is not particularly limited as long as the cerium salt can be dissolved and the etching treatment is not affected, but water is preferable. It is also preferable to use as a solvent a mixture of water and an inorganic acid.
When $(NH_4)_2Ce(NO_3)_6$ is used in the present invention, the amount thereof added is greater than 0.5% from the viewpoint of the treatment capability of the etching liquid, and preferably at least 1.0%, and although the treatment speed increases as the concentration increases, from the viewpoint of solubility it is no greater than 70%, preferably no greater than 40%, more preferably 2.0% to 30% (in the present invention, 'at least 2.0% but no greater than 30%' is also expressed as '2.0% to 30%', the same applies below), and yet more preferable 5.0% to 15%. It is preferable for the etching liquid employing $(NH_4)_2Ce(NO_3)_6$ of the present invention to have a concentration in the above-mentioned range since the etching capability is excellent.

In the etching liquid of the present invention employing $(NH_4)_2Ce(NO_3)_6$, in order to prevent decomposition of the etching liquid, a stabilizer may be used, and it is preferable for the etching liquid to comprise a stabilizer. The stabilizer is preferably $HNO_3$ or $HClO_4$. When $HNO_3$ is used as the stabilizer, the concentration thereof is preferably greater than 0.1% but no greater than 70%, more preferably 1.0% to 60%, yet more preferably 5% to 50%, and most preferably 10% to 20%. When $HClO_4$ is used as the stabilizer, the concentration thereof is preferably greater than 0.1% but no greater than 60%, more preferably 1.0% to 50%, and yet more preferably 5% to 40%. Sulfuric acid is not desirable as the stabilizer since it makes an $(NH_4)_2Ce(NO_3)_6$ etching liquid cloudy. In the etching liquid employing $(NH_4)_2Ce(NO_3)_6$ of the present invention, it is preferable for the stabilizer to have a concentration in the above-mentioned range since the etching liquid has improved stability.

When $Ce(SO_4)_2$ is used in the present invention, from the viewpoint of the treatment capability of the etching liquid, it is at least 0.5%, and preferably at least 1.0%, and although the treatment speed increases as the concentration increases, from the viewpoint of solubility it is no greater than 30%, preferably no greater than 25%, more preferably 2.0% to 25%, and yet more preferably 5% to 15%. In the etching liquid employing $Ce(SO_4)_2$ of the present invention, it is preferable for the concentration to be in the above-mentioned range since the etching capability is excellent.

In the etching liquid of the present invention employing $Ce(SO_4)_2$, in order to prevent degradation of the etching capability of $Ce(SO_4)_2$, a stabilizer may be used, and it is preferable for the etching liquid to comprise a stabilizer. The stabilizer is preferably $HNO_3$ or $H_2SO_4$, and more preferably $HNO_3$. When $HNO_3$ is used as the stabilizer, the concentration thereof is preferably greater than 0.1% but no greater than 70%, more preferably 1.0% to 60%, and yet more preferably 5.0% to 50%. When $H_2SO_4$ is used as the stabilizer, the concentration thereof is preferably greater than 0.1% but no greater than 40%, more preferably 1.0% to 30%, and yet more preferably 5.0% to 20%. In the etching liquid employing $Ce(SO_4)_2$ of the present invention, it is preferable for the stabilizer to have a concentration in the above-mentioned range since degradation of the etching capability of the etching liquid can be prevented.

The etching liquid of the present invention may employ $Ce(NO_3)_4$. The amount of $Ce(NO_3)_4$ used is at least 0.5% but no greater than 30%, and preferably 5.0% to 20%.

When $Ce(NO_3)_4$ is used, it is preferable to synthesize it immediately before it is used in the etching liquid. As a method for synthesizing $Ce(NO_3)_4$, a known method may be employed for the synthesis, and examples thereof include a method in which cerium hydroxide and nitric acid are added to ion exchanged water and heated. When $Ce(NO_3)_4$ is used, it is preferable to use $HNO_3$ as the stabilizer.

Needless to say, when the first etching liquid of the present invention comprises a stabilizer, the solubility of the etching liquid comprising $(NH_4)_2Ce(NO_3)_6$, $Ce(SO_4)_2$, or $Ce(NO_3)_4$ changes depending on the type of stabilizer, the temperature of the solution, the pH of the solution, the polarity of the solution, the common-ion effect, etc. When for example $(NH_4)_2Ce(NO_3)_6$ is used, the solubility might become 70% or less depending on the above-mentioned various conditions. In this case, the amount of $(NH_4)_2Ce(NO_3)_6$ used in the etching liquid of the present invention is greater than 0.1 wt % and no greater than an amount that gives a saturation concentration, and the same applies to $Ce(SO_4)_2$ or $Ce(NO_3)_4$.

As one example of the solubility, the saturation concentration of $(NH_4)_2Ce(NO_3)_6$ at each temperature when an $HNO_3$ aqueous solution was used was measured. The results are shown in Tables 1 and 2 below.

(Table 1)

| $HNO_3$ concentration (wt %) | Solubility of $(NH_4)_2Ce(NO_3)_6$ at 25°C (wt %) |
|---|---|
| 0 | 59,51 |
| 5.51 | 43.00 |
| 9.98 | 35.20 |
| 12.83 | 31.31 |
| 19.16 | 24.12 |
| 30.02 | 15.50 |
| 48.81 | 6.69 |
| 62.43 | 4.50 |
| 73.02 | 3.13 |
| 80.01 | 2.71 |

(continued)

| HNO$_3$ concentration (wt %) | Solubility of (NH$_4$)$_2$Ce(NO$_3$)$_6$ at 25°C (wt %) |
|---|---|
| 88.95 | 2.60 |

(Table 2)

| HNO$_3$ concentration (wt %) | Solubility of (NH$_4$)$_2$Ce(NO$_3$)$_6$ at 50°C (wt %) |
|---|---|
| 0 | 65.55 |
| 6.48 | 47.51 |
| 9.98 | 40.49 |
| 14.89 | 32.84 |
| 24.39 | 22.51 |
| 31.31 | 17.69 |
| 42.52 | 12.11 |
| 61.31 | 5.26 |
| 80.01 | 4.30 |

(2) Etching liquid comprising greater than 0.5 wt % but no greater than 30 wt % of (NH$_4$)$_4$Ce(SO$_4$)$_4$

A solvent of the second etching liquid of the present invention is not particularly limited as long as the cerium salt can be dissolved and the etching treatment is not affected, but water is preferable. It is also preferable to use as a solvent a mixture of water and an inorganic acid.

In the present invention, the content of (NH$_4$)$_4$Ce(SO$_4$)$_4$ is an amount added that is greater than 0.5% from the viewpoint of the treatment capability of the etching liquid and is preferably at least 1.0%, and although the treatment speed increases as the concentration increases, from the viewpoint of solubility it is no greater than 30%, preferably no greater than 25%, more preferably 2.0% to 25%, and yet more preferably 5% to 15%. It is preferable for the etching liquid of the present invention to have a concentration in the above-mentioned range since the etching capability is excellent.

In the second etching liquid of the present invention, in order to prevent decomposition of the etching liquid, a stabilizer may be used, and it is preferable for the etching liquid to comprise a stabilizer. The stabilizer is preferably H$_2$SO$_4$. When H$_2$SO$_4$ is used as the stabilizer, the concentration thereof is preferably greater than 1.0% but no greater than 40%, more preferably 2.0% to 30%, and yet more preferably 3% to 20%. Nitric acid is not desirable as the stabilizer since it makes the second etching liquid of the present invention comprising (NH$_4$)$_4$Ce(SO$_4$)$_4$ cloudy. In the second etching liquid of the present invention, it is preferable for the stabilizer to have a concentration in the above-mentioned range since the etching liquid has improved stability.

Needless to say, when the second etching liquid of the present invention comprises a stabilizer, the solubility of the etching liquid comprising (NH$_4$)$_4$Ce(SO$_4$)$_4$ changes depending on the type of stabilizer, the temperature of the solution, the pH of the solution, the polarity of the solution, the common-ion effect, etc. For example, depending on the above-mentioned various conditions the solubility of (NH$_4$)$_4$Ce(SO$_4$)$_4$ in the etching liquid might become 30% or less. In this case, the amount of (NH$_4$)$_4$Ce(SO$_4$)$_4$ used in the etching liquid of the present invention is greater than 0.5 wt % and no greater than an amount that gives a saturation concentration.

(3) Etching liquid comprising hypochlorous acid salt aqueous solution having effective chlorine concentration of at least 0.06 wt % and pH of greater than 3 but less than 8

The third etching liquid of the present invention comprises an aqueous solution of a hypochlorous acid salt; examples of the salt include an alkali metal salt and an alkaline earth metal salt, and an alkali metal salt is preferable. The alkali metal salt is preferably a sodium salt or a potassium salt, and more preferably a sodium salt. The alkaline earth metal salt is preferably a calcium salt.

A solvent of the third etching liquid of the present invention is not particularly limited as long as it is a medium that does not affect the etching treatment, but water is preferable.

Since a hypochlorous acid salt is produced by an alkali metal hydroxide or an alkaline earth metal hydroxide absorbing chlorine, an aqueous solution thereof exhibits strong alkalinity due to the influence of unreacted alkali metal hydroxide or alkaline earth metal hydroxide. Since an etching liquid for a conductive polymer exhibiting strong alkalinity adversely affects a resist, the pH of the third etching liquid of the present invention is greater than 3 but less than 8, preferably 4 to 7.5, more preferably 4.5 to 7, and yet more preferably 5 to 6.

When the pH of the etching liquid is 8 or greater, a resist is adversely affected. When the pH is 3 or less, due to the generation of chlorine gas the effective chlorine concentration in the etching liquid decreases, the time required for etching increases, and the chlorine gas thus generated damages an etching machine or equipment nearly. It is preferable for the etching liquid to have a pH of at least 4.0 since there is hardly any chlorine gas generated, and it is particularly preferable for the pH to be at least 4.5 since there is no chlorine gas generated.

In the present invention, an acid is added in order that the pH of the etching liquid is in the above-mentioned range. As the acid added, either an inorganic acid or an organic acid may be used.

Specific preferred examples thereof include hydrochloric acid, sulfuric acid, nitric acid, phosphoric acid, acetic acid, and citric acid, and among them sulfuric acid and nitric acid are more preferable.

The pH of the etching liquid of the present invention may be measured using a commercial pH meter.

The third etching liquid for a conductive polymer of the present invention has an effective chlorine concentration of hypochlorous acid of at least 0.06 wt %. When the effective chlorine concentration of the etching liquid is less than 0.06 wt %, sufficient etching capability cannot be obtained.

The effective chlorine concentration is more preferably at least 0.1% and yet more preferably at least 0.2%, and is preferably no greater than 3%, more preferably no greater than 2%, and yet more preferably no greater than 1%. It is preferable for the third etching liquid of the present invention to have an effective chlorine concentration in this range since etching of a conductive polymer can be carried out efficiently.

In the present invention, the effective chlorine concentration is measured by a titration method with $Na_2S_2O_3$. That is, W g of a sample to be measured is weighed and diluted to 250 mL with ion exchanged water. 10 mL of this sample liquid is taken and 10 mL of a 10% aqueous solution of potassium iodide is added thereto. 10 mL of acetic acid (1:2) is added so as to make the pH acidic, and titration is carried out using a 0.1 N aqueous solution of sodium thiosulfate (soluble starch is added partway through titration in order to make judgment of the end point easy). Effective chlorine concentration is determined from the following equation using the titer of 0.1 N $Na_2S_2O_3$ and the amount W of sample weighed.

$$\text{Effective chlorine concentration (\%) =}$$

$$0.003546 \times (Na_2S_2O_3 \text{ titer: mL}) \times 100/W/(10/250)$$

In the etching liquid of the present invention, control of the concentration of hypochlorous acid salt is possible by oxidation reduction potential, pH, electroconductivity, specific gravity, etc., or a combination thereof.

(4) Etching liquid comprising nitrosyl chloride which comprises at least 5 wt % of hydrochloric acid and at least 20 wt % of nitric acid, a (hydrochloric acid concentration + 0.51 x nitric acid concentration) value being no greater than 35 wt %, and a (hydrochloric acid concentration + 0.5 x nitric acid concentration) value being at least 30 wt %

Nitrosyl chloride is generated together with active chlorine by mixing hydrochloric acid and nitric acid as shown in the formula below.

$$HNO_3 + 3HCl \rightarrow NOCl + Cl_2 + 2H_2O$$

The nitrosyl chloride-containing etching liquid, which is the fourth etching liquid of the present invention, is a mixture of hydrochloric acid and nitric acid comprising at least 5% of hydrochloric acid and at least 20% of nitric acid, the value of (hydrochloric acid concentration + 0.51 x nitric acid concentration) being no greater than 35%, and the value of (hydrochloric acid concentration + 0.5 x nitric acid concentration) being at least 30%.

In the nitrosyl chloride-containing etching liquid, the nitric acid concentration is at least 20%, preferably 25% to 50%, and more preferably 30% to 40%. Furthermore, the etching liquid satisfies the following relationships: the concentration of hydrochloric acid is at least 5%, the value of the expression (hydrochloric acid concentration + 0.51 x nitric acid concentration) is no greater than 35%, and the value of the expression (hydrochloric acid concentration + 0.5 x nitric acid concentration) is at least 30%.

(5) Etching liquid comprising at least 3 wt % but no greater than 40 wt % of a bromic acid compound and at least 4 wt % of an inorganic acid

A bromic acid compound and a chloric acid compound, which is described later, have a low etching capability on their own, but their etching capability can be enhanced by combination with an acid.

In a bromic acid compound-containing etching liquid, which is the fifth etching liquid of the present invention, the bromic acid compound is an alkali metal salt of bromic acid, and is preferably a sodium salt or a potassium salt. The concentration of the bromic acid compound is 3% to 40%, preferably 5% to 35%, and more preferably 10% to 30%.

As the inorganic acid used in combination, phosphoric acid, nitric acid, and sulfuric acid can be cited as examples, and nitric acid and sulfuric acid are preferable. The concentration of the inorganic acid used in combination is preferably 4% to 30%, and more preferably 10% to 25%.

(6) Etching liquid comprising at least 6 wt % but no greater than 40 wt % of a chloric acid compound and at least 7 wt % of a hydrogen halide

In a chloric acid compound-containing etching liquid, which is the sixth etching liquid of the present invention, the chloric acid compound is an alkali metal salt of chloric acid, and is preferably a sodium salt or a potassium salt. The concentration of the chloric acid compound is 6% to 40%, and preferably 10% to 35%.

As an inorganic acid used in combination, a hydrogen halide is preferable; examples thereof include hydrochloric acid and hydrobromic acid, and hydrochloric acid is preferable. The concentration of the inorganic acid used in combination is preferably 7% to 30%, and more preferably 10% to 25%.

Nitrosyl chloride, the bromic acid compound, and the chloric acid compound described in (4) to (6) are compounds having oxidizing properties in common, and as another compound having oxidizing properties, (7) a permanganic acid compound and (8) a hexavalent chromium compound, which are described in detail later, are preferable.

(7) Etching liquid comprising at least 0.001 wt % but no greater than 20 wt % of a permanganic acid compound

In a permanganic acid compound-containing etching liquid, which is the seventh etching liquid of the present invention, the permanganic acid compound is preferably an alkali metal salt, and is more preferably a sodium salt or a potassium salt. The concentration of the permanganic acid compound is 0.001% to 20%, preferably 0.01% to 10%, and more preferably 0.1% to 5%.

An aqueous solution of the permanganic acid compound can become alkaline due to the influence of its counterion. Since an alkaline etching liquid can adversely affect a resist, it is preferable to add an acid so as to make it acidic.

As the acid used in combination with the permanganic acid compound, there are an organic acid and an inorganic acid, and in the present invention an inorganic acid is preferable. In the present invention, examples of the organic acid include formic acid, acetic acid, and propionic acid, and acetic acid is preferable. Examples of the inorganic acid include phosphoric acid, nitric acid, and sulfuric acid; nitric acid and sulfuric acid are preferable, and sulfuric acid is more preferable. The concentration of the acid used in combination is preferably 1% to 50%, and more preferably 5% to 25%.

(8) Etching liquid comprising at least 3 wt % but no greater than 30 wt % of a hexavalent chromium compound

As the eighth etching liquid of the present invention, an etching liquid comprising at least 3 wt % but no greater than 30 wt % of a hexavalent chromium compound may also be used as an etching liquid for a conductive polymer.

As the hexavalent chromium compound there are chromium oxide, a chromic acid compound, and a dichromic acid compound; examples of the chromic acid compound include an alkali metal salt thereof, examples of the dichromic acid compound also include an alkali metal salt thereof, and as the alkali metal salts thereof a sodium salt and a potassium salt are preferable. As an etching liquid using a hexavalent chromium compound in the present invention, rather than a chromic acid compound, chromium oxide or a dichromic acid compound is preferable, and chromium oxide is more preferable. The concentration of the hexavalent chromium compound used is 3% to 30%, preferably 5% to 25%, and more preferably 10% to 20%.

It is preferable to use an inorganic acid in combination with the hexavalent chromium compound; examples of the inorganic acid include phosphoric acid, nitric acid, and sulfuric acid, nitric acid and sulfuric acid are preferable, and sulfuric acid is more preferable. The concentration of the inorganic acid used in combination is preferably 1% to 50%, and more preferably 5% to 25%.

A solvent of the fourth to eighth etching liquids of the present invention is not particularly limited as long as it is a medium that does not affect the etching treatment, and water is preferable. As hereinbefore described, it is preferable to use as appropriate an organic acid or an inorganic acid in combination with water solvent, and it is more preferable to use an inorganic acid in combination.

The liquid temperature when carrying out etching using the first to eighth etching liquids of the present invention is preferably 10°C to 70°C, and more preferably 20°C to 60°C. It is preferable for the etching liquid of the present invention to be used in the above-mentioned liquid temperature range since the etching capability is excellent.

The etching time when using the etching liquid of the present invention is preferably 0.2 to 30 minutes, more preferably 0.3 to 25 minutes, and yet more preferably 0.4 to 15 minutes. It is preferable for the etching liquid of the present invention to be used in the above-mentioned etching time range since there is little damage to a substrate, etc. in the etching treatment. Furthermore, it is preferable since sufficient etching capability can be exhibited.

A patterning method employing the etching liquid of the present invention may be used either in an immersion method or a spray method.

Control of the concentration of the etching liquid of the present invention is possible by oxidation reduction potential, pH, electroconductivity, specific gravity, etc., or a combination thereof.

One example of the method for patterning a conductive polymer is explained by reference to FIG. 1.

FIG. 1A to FIG. 1G are schematic process drawings of one example in which a conductive polymer is etched by using the etching liquid of the present invention, thus giving a circuit pattern of the conductive polymer.

As an example of application of the etching liquid of the present invention, the top of a transparent substrate 1 (FIG. 1A) is coated with a conductive polymer 2 (FIG. 1B), a resist 3 (FIG. 1C) is applied (FIG. 1C) over the transparent substrate 1 (FIG. 1B), and exposure is carried out in accordance with a circuit diagram (FIG. 1D). The resist in the exposed section is removed by a developer, and the conductive polymer film is exposed (FIG. 1E). The conductive polymer film is patterned by etching the developed substrate using the etching liquid of the present invention (FIG. 1F). Subsequently, by washing and removing the remaining resist section the substrate with the conductive polymer film thus patterned is obtained (FIG. 1G). The conductive polymer layer preferably has a film thickness of 10 to 100 nm.

In FIG. 1, as the resist 3 a positive resist is used, but the present invention is not limited thereto, and a negative resist may be used.

The conductive polymer exhibits conductivity by $\pi$ electron transfer. A large number of such conductive polymers have been reported.

Examples of conductive polymers that can be used in the present invention include polyaniline, polythiophene, polypyrrole, polyphenylene, polyfluorene, polybithiophene, polyisothiophene, poly(3,4-ethylenedioxythiophene), polyisothianaphthene, polyisonaphthothiophene, polyacetylene, polydiacetylene, poly(paraphenylene vinylene), polyacene, polythiazyl, poly(ethylene vinylene), polyparaphenylene, polydodecylthiophene, poly(phenylene vinylene), poly(thienylene vinylene), polyphenylenesulfide, and derivatives thereof. Among them, polythiophenes and polyanilines are preferable, polythiophenes are more preferable, and poly(3,4-ethylenedioxythiophene), which has excellent electroconductivity and excellent stability and heat resistance in air, is most preferable.

Furthermore, for the purpose of exhibiting higher electroconductivity when using a conductive polymer, a doping agent, called a dopant, may be used in combination. As the dopant used in the above-mentioned conductive polymer, a known dopant may be used, and depending on the type of conductive polymer, a halogen (bromine, iodine, chlorine, etc.), a Lewis acid ($BF_3$, $PF_5$, etc.), a protonic acid ($HNO_3$, $H_2SO_4$, etc.), a transition metal halide ($FeCl_3$, $MoCl_5$, etc.), an alkali metal (Li, Na, etc.), an organic material (amino acid, nucleic acid, surfactant, colorant, alkylammonium ion, chloranil, tetracyanoethylene (TCNE), 7,7,8,8-tetracyanoquinodimethane (TCNQ), etc.), etc. can be cited. A self-doping type conductive polymer, which is a conductive polymer itself having a doping effect, may be used. Furthermore, when a polythiophene is used as the conductive polymer, it is preferable to use polystyrenesulfonic acid as a dopant.

The conductivity of the conductive polymer that can be used in the present invention is not particularly limited as long as conductivity is exhibited, and it is preferably $10^{-6}$ to $10^4$ S/cm, more preferably $10^{-5.5}$ to $10^3$ S/cm, and yet more preferably $10^{-5}$ to $5 \times 10^2$ S/cm. It is preferable for the conductivity of the conductive polymer used in the present invention to be in the above-mentioned range since it is suitable for patterning, etc. of a connected section.

Furthermore, in the present invention, the conductive polymer after film formation preferably has high transmittance in the visible light region when used. The transmittance is preferably 60% to 98% at a wavelength of 550 nm, more preferably 70% to 95%, and yet more preferably 80% to 93%. When the conductive polymer itself has a transmittance in the above-mentioned range, it may suitably be used in applications such as displays.

In the present invention, the visible light region is 400 to 700 nm. Measurement of transmittance may be carried out using a spectrophotometer.

Various types of conductive polymers are commercially available. A polyaniline marketed under the product name 'Panipol', manufactured by Panipol, is an organic solvent-soluble polyaniline doped with a functional sulfonic acid. A polyaniline marketed under the product name 'Ormecon', manufactured by Ormecon, is a solvent-dispersed polyaniline employing an organic acid as a dopant. A poly(3,4-ethylenedioxythiophene) marketed under the product name 'Baytron', manufactured by Bayer, employs polystyrenesulfonic acid as a dopant. In addition thereto, a polypyrrole marketed under the product name 'ST Poly', manufactured by Achilles Corporation, a sulfonated polyaniline marketed under the product name 'PETMAX', manufactured by Toyobo Co., Ltd., and a polyaniline marketed under the product name 'SCS-NEO', manufactured by Maruai Inc. may also be used in the present invention.

A conductive polymer described in Kagaku (Chemistry) 6 'Yukidoudensei Porima' (Organic Conductive Polymers) 2001 of a patent licensing support chart as an enterprise for encouraging patent licensing may also be used in the present invention.

When a conductive polymer is patterned by etching using the etching liquid of the present invention, it is necessary to use a photoresist for protecting a section in which the conductive polymer is not dissolved by the etching liquid. With regard to the photoresist, there are a positive type in which a section that has been irradiated with UV rays is dissolved by a developer, and a negative type in which a section that has been irradiated with UV rays becomes insoluble in a developer.

For the positive type, many liquid resists exist, and it is used in etching with a line width of on the order of a few $\mu$m for, for example, a display such as an LCD (Liquid Crystal Display).

For the negative type, many dry film resists exist, and it is used in etching with a line width of on the order of a few tens of $\mu$m for, for example, a display such as a PDP (Plasma Display Panel).

Both the positive type resist and the negative type resist can be used in the present invention, and the positive type and the negative type may be selected according to the degree of definition of an intended pattern.

As a photoresist, a resist that can be removed using an alkali is preferable, and a liquid resist is more preferable.

The substrate is not particularly limited and may be selected according to an intended application; specific examples thereof include glass, quartz, polyester (e.g. polyethylene terephthalate, polyethylene naphthalate, etc.), polyolefin (e.g. polyethylene, polypropylene, polystyrene, etc.), polyimide, polyacrylate, and polymethacrylate.

Since the etching liquid of the present invention has excellent etching capability for a conductive polymer, practical etching of a conductive polymer can be carried out.

The etching liquid for a conductive polymer of the present invention and the patterning method of the present invention may be applied to etching of a conductive polymer used in an electrolytic capacitor, a battery, a touch panel, a liquid crystal panel, an organic EL element, etc.

It can therefore be expected that application of conductive polymers will be promoted in uses where etching is required such as patterning of a conductive polymer in a display pixel section of a display represented by a polymer organic EL display and patterning of a section where a peripheral circuit and the conductive polymer are connected, patterning of a conductive polymer in a detection section of a touch panel and patterning of a section where a peripheral circuit and the conductive polymer are connected, or removal of a conductive polymer attached to an unwanted section during production of a capacitor.

Examples

The present invention is explained below by reference to Examples, but the present invention should not be construed as being limited by these Examples.

Unless otherwise specified, '%' denotes 'wt %'.

Example 1-1

A test substrate (B) was prepared by forming on the surface of a polyethylene terephthalate (PET) sheet a thin film of about 50 nm using as a conductive polymer BAYTRON F E (trade name, manufactured by Starck, containing poly(3,4-ethylenedioxythiophene)).

A dry film resist, product name ORDYL LF525 (manufactured by Tokyo Ohka Kogyo Co., Ltd.) was affixed to the test substrate (B) using a laminator, thus giving a test substrate (C). The test substrate (C) to which the dry film resist was affixed was exposed to UV rays while being held in close contact with a master pattern using a frame-type vacuum exposure unit, thus giving a test substrate (D). The exposed test substrate (D) was developed by spraying at a spray pressure of 1 MPa using a 1% $Na_2CO_3$ aqueous solution as a developer while regulating the temperature at 30°C, thus giving a test substrate (E).

The developed test substrate (E) was washed with water and immersed in a 20% concentration aqueous solution of $(NH_4)_2Ce(NO_3)_6$ (liquid temperature 30°C) to carry out etching, thus giving a test substrate (F). This etching was carried out for 30 minutes at the longest.

The etched test substrate (F) was immersed in a 3% NaOH aqueous solution for 2 minutes while regulating the liquid temperature at 30°C to peel off the dry film resist, thus giving a test substrate (G).

The test substrate (G) from which the dry film resist had been peeled off was washed with water and dried by blowing air thereonto.

The dried test substrate was examined using a scanning electron microscope, and it was ascertained whether or not there was etching residue of conductive polymer in the etched section and whether or not the PET substrate was exposed.

Here, the time required for etching was defined as described below, and the time required for etching was evaluated. That is, an immersion time in an etching liquid required for etching residue of conductive polymer on the substrate to be eliminated was defined as the time required for etching. The results are given in Table 3. The surface of the conductive polymer covered by the dry film resist showed no change due to etching. Furthermore, there was no change in the substrate due to etching.

Examples 1-2 to 1-5 and Comparative Example 1-1

An etching treatment was carried out in the same manner as in Example 1-1 except that the concentration of the aqueous solution of $(NH_4)_2Ce(NO_3)_6$ was changed to 10% for Example 1-2, 5% for Example 1-3, 2% for Example 1-4, 1 % for Example 1-5, and 0.5% for Comparative Example 1-1, and these results are given in Table 3. The surface of the conductive polymer covered by the dry film resist showed no change due to etching. Furthermore, there was no change in the substrate due to etching.

(Table 3)

| | $(NH_4)_2Ce(NO_3)_6$ (%) | Time required for etching |
|---|---|---|
| Example 1-1 | 20 | Excellent |
| Example 1-2 | 10 | Excellent |
| Example 1-3 | 5 | Excellent |
| Example 1-4 | 2 | Good |
| Example 1-5 | 1 | Fair |
| Comp. Ex. 1-1 | 0.5 | Poor |

Criteria for time required for etching

With regard to the criteria for the time required for etching in Table 3 to Table 7, the time taken from starting etching until attaining a state in which there was no etching residue of conductive polymer in the section from which the dry film resist had been removed and the PET substrate was exposed was measured and evaluated as follows.

Poor: at least 30 minutes
Fair: at least 5 minutes but less than 30 minutes
Good: at least 1 minute but less than 5 minutes
Excellent: less than 1 minute

Example 1-6

Using 100 g of an etching liquid containing 10.0% of $(NH_4)_2Ce(NO_3)_6$ and 1.0% of $HNO_3$, evaluation of the time required for etching was carried out using the etching liquid immediately after being prepared by the same method as in Example 1-1. Furthermore, the etching liquid was allowed to stand for 72 hours while maintaining the liquid temperature at 30°C, and the presence or absence of a precipitate from the etching liquid after standing for 72 hours was checked visually. The results are given in Table 4.
When the same treatment as in Example 1-1 was carried out using this etching liquid after 72 hours, etching of a conductive polymer was possible.
The surface of the conductive polymer covered by the dry film resist showed no change due to etching. Furthermore, there was no change in the substrate due to etching.

Example 1-7

Evaluation of the time required for etching was carried out using an etching liquid immediately after being prepared by the same method as in Example 1-6 except that $(NH_4)_2Ce(NO_3)_6$ was 10.0% and $HClO_4$ was 1.0% in the etching liquid composition, and the presence or absence of a precipitate from the etching liquid was checked visually. The results are given in Table 4.
Furthermore, when the same treatment as in Example 1-1 was carried out using the etching liquid which had stood for 72 hours and for which the presence or absence of a precipitate from the etching liquid had been checked, etching of a conductive polymer was possible.
The surface of the conductive polymer covered by the dry film resist showed no change due to etching. Furthermore, there was no change in the substrate due to etching.

Examples 1-8 to 1-11

The presence or absence of a precipitate from an etching liquid was checked visually using the same method as in Example 1-6 except that the composition of the etching liquid was as the concentrations shown in Table 4. The results are given in Table 4.
The surface of the conductive polymer covered by the dry film resist showed no change due to etching. Furthermore, there was no change in the substrate due to etching.
In Table 4 below, '-' means that measurement was not carried out.

(Table 4)

| | (NH$_4$)$_2$Ce (NO$_3$)$_6$ (%) | HNO$_3$ (%) | HClO$_4$ (%) | Time required for etching immediately after preparation | Etching liquid stability | Time required for etching after 72 hours |
|---|---|---|---|---|---|---|
| Example 1-6 | 10 | 1 | 0 | Excellent | Good | Excellent |
| Example 1-7 | 10 | 0 | 1 | Excellent | Good | Excellent |
| Example 1-8 | 10 | 0 | 0 | Excellent | Poor | - |
| Example 1-9 | 10 | 0.1 | 0 | Excellent | Poor | - |
| Example 1-10 | 10 | 0 | 0.1 | Excellent | Poor | - |
| Example 1-11 | 10 | 15 | 0 | Excellent | Good | Excellent |

Criteria for etching liquid stability

Criteria for etching liquid stability in Table 4 and Table 6 involved allowing 100 g of an etching liquid to stand for 72 hours while maintaining the liquid temperature at 30°C, visually checking the presence or absence of a precipitate from the etching liquid after standing, and evaluating as follows.
Poor: large amount of precipitate
Fair: trace amount of precipitate
Good: no precipitate

Examples 1-12 to 1-16 and Comparative Example 1-2

The time required for etching was determined by the same method as in Example 1-1 except that the concentration of Ce(SO$_4$)$_2$ shown in Table 5 was used. The results are given in Table 5.
The surface of the conductive polymer covered by the dry film resist showed no change due to etching. Furthermore, there was no change in the substrate due to etching.

(Table 5)

| | Ce(SO$_4$)$_2$ (%) | Time required for etching |
|---|---|---|
| Examples 1-12 | 20 | Excellent |
| Examples 1-13 | 15 | Excellent |
| Example 1-14 | 10 | Excellent |
| Example 1-15 | 5 | Good |
| Example 1-16 | 0.5 | Fair |
| Comp. Ex. 1-2 | 0.1 | Poor |

Examples 1-17 to 1-19

Evaluation of the time required for etching was carried out using an etching liquid immediately after being prepared by the same method as in Example 1-6 except that the concentration of Ce(SO$_4$)$_2$ shown in Table 6 and a solution of sulfuric acid or nitric acid were used, and the presence or absence of a precipitate from the etching liquid was checked visually. The results are given in Table 6.
Furthermore, the same treatment as in Example 1-1 was carried out using the etching liquid which had stood for 72 hours and for which the presence or absence of a precipitate from the etching liquid had been checked, and the results are given in Table 6.
The surface of the conductive polymer covered by the dry film resist showed no change due to etching. Furthermore, there was no change in the substrate due to etching.

(Table 6)

| | $Ce(SO_4)_2$ (%) | $H_2SO_4$ (%) | $HNO_3$ (%) | Time required for etching immediately after preparation | Etching liquid stability | Time required or etching after 72 hours |
|---|---|---|---|---|---|---|
| Example 1-17 | 0.8 | 0 | 0 | Fair | Good | Poor |
| Example 1-18 | 0.8 | 5 | 0 | Fair | Good | Fair |
| Example 1-19 | 0.8 | 0 | 5 | Excellent | Good | Excellent |

Examples 1-20 to 1-23

The time required for etching was determined by the same method as in Example 1-1 except that an etching component with a concentration shown in Table 7 and a conductive polymer shown in Table 7 were used. The results are given in Table 7.

The surface of the conductive polymer covered by the dry film resist showed no change due to etching. Furthermore, there was no change in the substrate due to etching.

(Table 7)

| | Etching liquid component | Sulfonated polyaniline | Polypyrrole |
|---|---|---|---|
| | | Time required for etching | Time required for etching |
| Example 1-20 | $(NH_4)_2Ce(NO_3)_6$ 10% | Excellent | Excellent |
| Example 1-21 | $(NH_4)_2Ce(NO_3)_6$ 10% + $HNO_3$ 10% | Excellent | Excellent |
| Example 1-22 | $(NH_4)_2Ce(NO_3)_6$ 10% + $HClO_4$ 10% | Excellent | Excellent |
| Example 1-23 | $Ce(SO_4)_2$ 10% | Excellent | Excellent |

Example 2-1

A test substrate (B) was prepared by forming on the surface of a polyethylene terephthalate (PET) sheet a thin film of about 50 nm using as a conductive polymer BAYTRON F E (trade name, manufactured by Starck, containing poly(3,4-ethylenedioxythiophene)).

A dry film resist, product name ORDYL LF525 (manufactured by Tokyo Ohka Kogyo Co., Ltd.) was affixed to the test substrate (B) using a laminator, thus giving a test substrate (C). The test substrate (C) to which the dry film resist was affixed was exposed to UV rays while being held in close contact with a master pattern using a frame-type vacuum exposure unit, thus giving a test substrate (D). The exposed test substrate (D) was developed by spraying at a spray pressure of 1 MPa using a 1% $Na_2CO_3$ aqueous solution as a developer while regulating the temperature at 30°C, thus giving a test substrate (E).

The developed test substrate (E) was washed with water and immersed in a 5% concentration aqueous solution of $(NH_4)_4Ce(SO_4)_4$ (liquid temperature 30°C) to carry out etching, thus giving a test substrate (F). This etching was carried out for 30 minutes at the longest.

The etched test substrate (F) was immersed in a 3% NaOH aqueous solution for 2 minutes while regulating the liquid temperature at 30°C to peel off the dry film resist, thus giving a test substrate (G).

The test substrate (G) from which the dry film resist had been peeled off was washed with water and dried by blowing air thereonto.

The dried test substrate was examined using a scanning electron microscope, and it was ascertained whether or not there was etching residue of conductive polymer in the etched section and whether or not the PET substrate was exposed.

Here, the time required for etching was defined as described below, and the time required for etching was evaluated. That is, an immersion time in an etching liquid required for etching residue of conductive polymer on the substrate to be eliminated was defined as the time required for etching. The results are given in Table 8. The surface of the conductive polymer covered by the dry film resist showed no change due to etching. Furthermore, there was no change in the substrate due to etching.

Criteria for time required for etching

With regard to the criteria for the time required for etching in Table 8 to Table 10, the time taken from starting etching until attaining a state in which there was no etching residue of conductive polymer in the section from which the dry film resist had been removed and the PET substrate was exposed was measured and evaluated as follows.
Poor: at least 30 minutes
Fair: at least 5 minutes but less than 30 minutes
Good: at least 1 minute but less than 5 minutes
Excellent: less than 1 minute

Example 2-2, Example 2-3, and Comparative Example 2-1

The time required for etching was determined by the same method as in Example 2-1 except that a concentration shown in Table 8 was used. The results are given in Table 8.
The surface of the conductive polymer covered by the dry film resist showed no change due to etching. Furthermore, there was no change in the substrate due to etching.

(Table 8)

|  | $(NH_4)_4Ce(SO_4)_4$ (%) | Time required for etching |
|---|---|---|
| Example 2-1 | 5 | Good |
| Example 2-2 | 2 | Good |
| Example 2-3 | 1 | Fair |
| Comp. Ex. 2-1 | 0.5 | Poor |

Example 2-4

Using 100 g of an etching liquid containing 5.0% of $(NH_4)_4Ce(SO_4)_4$ and 5.0% of $H_2SO_4$, evaluation of the time required for etching was carried out using the etching liquid immediately after being prepared by the same method as in Example 2-1. Furthermore, the etching liquid was allowed to stand for 72 hours while maintaining the liquid temperature at 30°C, and the presence or absence of a precipitate from the etching liquid after standing for 72 hours was checked visually. The results are given in Table 9.
When the same treatment as in Example 2-1 was carried out using this etching liquid which had stood for 72 hours and for which the presence or absence of a precipitate from the etching liquid had been checked, etching of a conductive polymer was possible.
The surface of the conductive polymer covered by the dry film resist showed no change due to etching. Furthermore, there was no change in the substrate due to etching.

Examples 2-5 and 2-6

Evaluation of the time required for etching was carried out using an etching liquid immediately after being prepared by the same method as in Example 2-4 except that the composition of the etching liquid was as the concentrations shown in Table 9, and the presence or absence of a precipitate from the etching liquid was checked visually. The results are given in Table 9.
The surface of the conductive polymer covered by the dry film resist showed no change due to etching. Furthermore, there was no change in the substrate due to etching.

(Table 9)

|  | $(NH_4)_4Ce(SO_4)_4$ (%) | $H_2SO_4$ (%) | Time required for etching immediately after preparation | Etching liquid stability | Time required for etching after 72 hours |
|---|---|---|---|---|---|
| Example 2-4 | 5 | 5 | Good | Good | Good |

(continued)

|  | (NH$_4$)$_4$Ce(SO$_4$)$_4$ (%) | H$_2$SO$_4$ (%) | Time required for etching immediately after preparation | Etching liquid stability | Time required for etching after 72 hours |
|---|---|---|---|---|---|
| Example 2-5 | 5 | 1 | Good | Poor | - |
| Example 2-6 | 5 | 0 | Good | Poor | - |

Criteria for etching liquid stability

Criteria for etching liquid stability in Table 9 involved allowing 100 g of an etching liquid to stand for 72 hours while maintaining the liquid temperature at 30°C, visually checking the presence or absence of a precipitate from the etching liquid after standing, and evaluating as follows.
Poor: large amount of precipitate
Fair: trace amount of precipitate
Good: no precipitate

Examples 2-7 and 2-8

The time required for etching was determined by the same method as in Example 2-1 except that an etching component with a concentration shown in Table 10 and a conductive polymer shown in Table 10 were used. The results are given in Table 10.
The surface of the conductive polymer covered by the dry film resist showed no change due to etching. Furthermore, there was no change in the substrate due to etching.

(Table 10)

|  | Etching liquid component | Sulfonated polyaniline | Polypyrrole |
|---|---|---|---|
|  |  | Time required for etching | Time required for etching |
| Example 2-7 | (NH$_4$)$_4$Ce(SO$_4$)$_4$ 5% | Excellent | Excellent |
| Example 2-8 | (NH$_4$)$_4$Ce(SO$_4$)$_4$ 10% + H$_2$SO$_4$ 10% | Excellent | Excellent |

Examples 3-1 to 3-14 and Comparative Examples 3-1 to 3-8

A test substrate (B) was prepared by forming on the surface of a polyethylene terephthalate (PET) sheet a thin film (about 50 nm) using as a conductive polymer BAYTRON F E (trade name, manufactured by Starck, containing poly (3,4-ethylenedioxythiophene)).
A dry film resist (product name ORDYL LF525, manufactured by Tokyo Ohka Kogyo Co., Ltd.) was affixed to the test substrate (B) using a laminator, thus giving a test substrate (C).
The test substrate (C) to which the dry film resist was affixed was exposed to UV rays while being held in close contact with a master pattern using a frame-type vacuum exposure unit, thus giving a test substrate (D). The exposed test substrate (D) was developed by spraying at a spray pressure of 1 MPa using a 1% Na$_2$CO$_3$ aqueous solution as a developer while regulating the temperature at 30°C, thus giving a test substrate (E).
The developed test substrate (E) was washed with water and immersed in an aqueous solution of sodium hypochlorite to carry out etching (F). The effective chlorine concentration and the pH of the aqueous solution of sodium hypochlorite were as shown in Table 11 below. Furthermore, in Example 3-14, an aqueous solution of CaCl(ClO) (bleaching powder) (effective chlorine concentration 0.32%, pH 5.25) was used.
This etching was carried out for 30 minutes at the longest.
The pH was adjusted using 35% hydrochloric acid by diluting it with ion exchange water as appropriate.
The etched test substrate (F) was immersed in a 3% NaOH aqueous solution for 2 minutes while regulating the liquid temperature at 30°C to peel off the dry film resist (G).
The test substrate (G) from which the dry film resist had been peeled off was washed with water and dried by blowing air thereonto.
The dried test substrate was examined using a scanning electron microscope, and it was ascertained whether or not there was etching residue of conductive polymer in the etched section and whether or not the PET substrate was exposed.

Here, the time required for etching was defined as described below, and the time required for etching was evaluated. That is, an immersion time in an etching liquid required for etching residue of conductive polymer on the substrate to be eliminated was defined as the time required for etching. The results are given in Table 11. The surface of the conductive polymer covered by the dry film resist showed no change due to etching. Furthermore, there was no change in the substrate due to etching.

Furthermore, the developed test substrate was immersed in the etching liquid for a long time, and peel-off of the dry film resist was examined.

A method for measuring effective chlorine concentration employed a titration method using $Na_2S_2O_3$. That is, W g of a sample to be measured was weighed and diluted to 250 mL with ion exchanged water. 10 mL of this sample liquid was taken and 10 mL of a 10% aqueous solution of potassium iodide was added thereto. 10 mL of acetic acid (1: 2) was added so as to make the pH acidic, and titration was carried out using a 0.1 N aqueous solution of sodium thiosulfate (soluble starch was added partway through titration in order to make judgment of the end point easy). Effective chlorine concentration was determined from the following equation using the titer of 0.1 N $Na_2S_2O_3$ and the amount W of sample weighed.

$$0.003546 \times (Na_2S_2O_3 \text{ titer: mL}) \times 100/W/(10/250)$$

(Table 11)

| | Hypochlorous acid salt | Effective chlorine concentration (%) | pH | Time required for etching | Resist peel-off |
|---|---|---|---|---|---|
| Example 3-1 | Sodium hypochlorite | 0.98 | 5.02 | Excellent | Excellent |
| Example 3-2 | Sodium hypochlorite | 0.95 | 5.94 | Excellent | Excellent |
| Example 3-3 | Sodium hypochlorite | 0.94 | 5.86 | Excellent | Excellent |
| Example 3-4 | Sodium hypochlorite | 0.58 | 4.95 | Excellent | Excellent |
| Example 3-5 | Sodium hypochlorite | 0.56 | 6.97 | Excellent | Excellent |
| Example 3-6 | Sodium hypochlorite | 0.55 | 7.99 | Excellent | Good |
| Example 3-7 | Sodium hypochlorite | 0.23 | 5.83 | Excellent | Excellent |
| Example 3-8 | Sodium hypochlorite | 0.19 | 3.87 | Good | Excellent |
| Example 3-9 | Sodium hypochlorite | 0.12 | 4.98 | Good | Excellent |
| Example 3-10 | Sodium hypochlorite | 0.09 | 7.80 | Good | Good |
| Example 3-11 | Sodium hypochlorite | 0.08 | 4.89 | Good | Excellent |
| Example 3-12 | Sodium hypochlorite | 0.07 | 6.75 | Good | Excellent |
| Example 3-13 | Sodium hypochlorite | 0.06 | 5.18 | Good | Excellent |
| Example 3-14 | CaCl(ClO) | 0.32 | 5.25 | Good | Excellent |
| Comp. Ex. 3-1 | Sodium hypochlorite | 0.01 | 5.42 | Poor | Excellent |
| Comp. Ex. 3-2 | Sodium hypochlorite | 0.01 | 1.53 | Poor | Excellent |
| Comp. Ex. 3-3 | Sodium hypochlorite | 0.03 | 5.30 | Poor | Excellent |
| Comp. Ex. 3-4 | Sodium hypochlorite | 0.08 | 1.97 | Fair | Excellent |
| Comp. Ex. 3-5 | Sodium hypochlorite | 0.27 | 2.75 | Fair | Excellent |
| Comp. Ex. 3-6 | Sodium hypochlorite | 0.33 | 3.00 | Fair | Excellent |
| Comp. Ex. 3-7 | Sodium hypochlorite | 0.94 | 11.38 | Excellent | Poor |
| Comp. Ex. 3-8 | Sodium hypochlorite | 0.23 | 11.06 | Excellent | Poor |

In Table 11, Examples 3-1 to 3-14 in which an aqueous solution of a hypochlorous acid salt having an effective chlorine concentration of at least 0.06% and a pH of greater than 3 and less than 8 was used as the etching liquid gave good results for both the time required for etching and the resist peel-off.

In contrast, Comparative Examples 3-1 to 3-8 in which an etching liquid having an effective chlorine concentration or a pH outside the above-mentioned ranges was used had problems with the time required for etching and/or the resist peel-off. Furthermore, in Comparative Example 3-5 and Comparative Example 3-6, the effective chloride concentrations were 0.27% and 0.33% respectively when measured but the effective chlorine concentrations during etching were thought to be lower due to decrease in the effective chlorine concentration over time.

In Table 11, the time required for etching and the resist peel-off were evaluated in accordance with the criteria below.

Criteria for time required for etching

Poor: longer than 30 minutes

Fair: longer than 5 minutes but no longer than 30 minutes

Good: longer than 1 minute but no longer than 5 minutes

Excellent: no longer than 1 minute

Criteria for resist peel-off

Poor: resist peel-off occurred after less than 15 minutes.

Fair: resist peel-off occurred after at least 15 minutes but less than 20 minutes.

Good: resist peel-off occurred after at least 20 minutes but less than 30 minutes.

Excellent: resist peel-off did not occur even after 30 minutes had elapsed.


Examples 3-15


The time required for etching was measured in the same manner as in Example 3-1 except that an etching liquid shown in Table 12 was used and a conductive polymer shown in Table 12 was used.

The results are given in Table 12.


(Table 12)

|  | Etching liquid | Conductive polymer | |
|---|---|---|---|
|  |  | Sulfonated polyaniline | Polypyrrole |
| Example 3-15 | Effective chlorine concentration 0.32% pH 5.56 | Excellent | Excellent |


Example 3-16 and Comparative Examples 3-9 to 3-12


The time required for etching and resist peel-off were evaluated in the same manner as in Example 3-1 except that the effective chlorine concentration was 0.99 wt % and the pH was as shown in Table 13. The results are given in Table 13.


(Table 13)

|  | Effective chlorine concentration (%) | pH | Time required for etching | Resist peel-off |
|---|---|---|---|---|
| Example 3-16 | 0.99 | 6.97 | Excellent | Excellent |
| Comp. Ex. 3-9 | 0.99 | 8.00 | Excellent | Fair |
| Comp. Ex. 3-10 | 0.99 | 9.24 | Excellent | Fair |
| Comp. Ex. 3-11 | 0.99 | 10.13 | Excellent | Poor |
| Comp. Ex. 3-12 | 0.99 | 11.03 | Excellent | Poor |


Examples 3-17 to 3-20


The time required for etching and resist peel-off were evaluated as in Example 3-1 by adjusting the pH of an etching liquid for a conductive polymer using an acid shown below. The acid used for adjustment of pH was used by diluting with water as appropriate as in Example 3-1.

The results are given in Table 14.

(Table 14)

|  | pH adjustment | Effective chlorine concentration (%) | pH | Time required for etching | Resist peel-off |
|---|---|---|---|---|---|
| Example 3-17 | Sulfuric acid | 0.82 | 5.93 | Excellent | Excellent |
| Example 3-18 | Nitric acid | 0.81 | 6.16 | Excellent | Excellent |
| Example 3-19 | Phosphoric acid | 0.78 | 6.11 | Excellent | Excellent |
| Example 3-20 | Acetic acid | 0.83 | 5.90 | Excellent | Excellent |

Examples 4-1 to 4-5

A test substrate (B) was prepared by forming on the surface of a polyethylene terephthalate (PET) sheet a thin film with a dry film thickness of about 50 nm using as a conductive polymer BAYTRON P (trade name, manufactured by Starck, containing poly(3,4-ethylenedioxythiophene)). A dry film resist, product name ORDYL LF525 (manufactured by Tokyo Ohka Kogyo Co., Ltd.) was affixed (C) to the test substrate (B) using a laminator. The test substrate (C) to which the dry film resist was affixed was exposed (D) to UV rays while being held in close contact with a master pattern using a frame-type vacuum exposure unlit. The exposed test substrate (D) was developed (E) by spraying at a spray pressure of 1 MPa using a 1% $Na_2CO_3$ aqueous solution as a developer while regulating the temperature at 30°C. As Example 4-1, the developed test substrate (E) was washed with water and immersed in an aqueous solution with 16.1% of HCl and 32.3% of $HNO_3$ (a mixture of conc. hydrochloric acid, conc. nitric acid, and ion exchanged water) at a liquid temperature of 30°C to carry out etching (F). This etching was carried out for 30 minutes at the longest.

The etched test substrate (F) was immersed in a 3% NaOH aqueous solution for 2 minutes while regulating the liquid temperature at 30°C to peel off the dry film resist (G).

The test substrate (G) from which the dry film resist had been peeled off was washed with water and dried by blowing dry air thereonto.

As Examples 4-2 to 4-5, the concentrations of HCl and $HNO_3$ were changed as shown in Table 15, and the same procedure as in Example 4-1 was otherwise carried out.

The dried test substrate was examined using a scanning electron microscope, and it was ascertained whether or not there was etching residue of conductive polymer in a section from which the dry film resist was removed by the developer and whether or not the PET substrate was exposed. This evaluation was as follows: immersion time in an etching liquid required for conductive polymer on the substrate to be eliminated was defined as the time required for etching. The results are given in Table 15.

Criteria for the time required for etching were as follows.

Poor: longer than 30 minutes
Fair: within 5 to 30 minutes
Good: within 1 to 5 minutes

Comparative Examples 4-1 to 4-7

The time required for etching was determined by the same method as in Example 4-1 except that the composition of the etching liquid was as the components shown in the table, and the results are given in Table 15 together with those of the Examples.

(Table 15)

|  | HCl wt% | $HNO_3$ wt% | Time required for etching |
|---|---|---|---|
| Example 4-1 | 16.1 | 32.3 | Good |
| Example 4-2 | 20.0 | 20.0 | Fair |
| Example 4-3 | 15.0 | 30.0 | Fair |
| Example 4-4 | 10.0 | 40.0 | Fair |
| Example 4-5 | 5.0 | 50.0 | Fair |
| Comp. Ex. 4-1 | 10.0 | 20.0 | Poor |

(continued)

| | HCl wt % | HNO$_3$ wt% | Time required for etching |
|---|---|---|---|
| Comp. Ex. 4-2 | 16.1 | 0.0 | Poor |
| Comp. Ex. 4-3 | 0.0 | 32.3 | Poor |
| Comp. Ex. 4-4 | 20.0 | 15.0 | Poor |
| Comp. Ex. 4-5 | 15.0 | 20.0 | Poor |
| Comp. Ex. 4-6 | 10.0 | 30.0 | Poor |
| Comp. Ex. 4-7 | 5.0 | 40.0 | Poor |

Criteria for the time required for etching were as follows.
Poor: longer than 30 minutes
Fair: within 5 to 30 minutes
Good: within 1 to 5 minutes
Excellent: within 1 minute

Examples 4-6 to 4-16

The time required for etching was determined by the same method as in Example 4-1 except that the composition of an etching liquid containing 3 to 40 wt % of a bromic acid compound was as shown in Table 16, and the results are given in Table 16 together with the compositions.

Comparative Examples 4-8 to 4-15

The time required for etching was determined by the same method as in Example 4-1 except that the composition of an etching liquid was as the components shown in the table, and the results are given in Table 16.

(Table 16)

| | NaBrO$_3$ wt % | KBrO$_3$ wt % | HCl wt % | H$_3$PO$_4$ | HNO$_3$ wt % | H$_2$SO$_4$ wt % | Time required for etching |
|---|---|---|---|---|---|---|---|
| Example 4-6 | 20 | - | - | - | - | 20 | Excellent |
| Example 4-7 | 6 | - | 10 | - | - | - | Fair |
| Example 4-8 | 6 | - | - | 10 | - | - | Fair |
| Example 4-9 | 6 | - | - | - | 10 | - | Fair |
| Example 4-10 | 6 | - | - | - | - | 10 | Fair |
| Example 4-11 | 3 | - | - | - | - | 10 | Fair |
| Example 4-12 | 6 | - | - | - | - | 4 | Fair |
| Example 4-13 | - 6 | | 10 | - | - | - | Fair |
| Example 4-14 | - | 6 | - | 10 | - | - | Fair |
| Example 4-15 | - | 6 | - | - | 10 | - | Fair |
| Example 4-16 | - 6 | | - | - | - | 10 | Fair |
| Comp. Ex. 4-8 | 2 | - | - | - | - | 10 | Poor |
| Comp. Ex. 4-9 | 6 | - | - | - | - | 3 | Poor |
| Comp. Ex. 4-10 | 6 | - | - | - | - | - | Poor |
| Comp. Ex. 4-11 | - | 6 | - | - | - | - | Poor |

(continued)

| | NaBrO$_3$ wt % | KBrO$_3$ wt % | HCl wt % | H$_3$PO$_4$ | HNO$_3$ wt % | H$_2$SO$_4$ wt % | Time required for etching |
|---|---|---|---|---|---|---|---|
| Comp. Ex. 4-12 | - | - | 10 | - | - | - | Poor |
| Comp. Ex. 4-13 | - | - | - | 10 | - | - | Poor |
| Comp. Ex. 4-14 | - | - | - | - | 10 | - | Poor |
| Comp. Ex. 4-15 | - | - | - | - | - | 10 | Poor |

In the table, '-' means that the component was not contained.

Criteria for the time required for etching were the same as those in Example 4-1.

Examples 4-17 to 4-19

The time required for etching was determined by the same method as in Example 4-1 except that the composition of an etching liquid containing 6 to 40 wt % of a chloric acid compound was as shown in Table 17, and the results are given in Table 17 together with the composition.

Comparative Examples 4-16 to 4-21

Time required for etching was determined by the same method as in Example 4-1 except that the composition of an etching liquid was as the components shown in Table 17, and the results are given in Table 17.

(Table 17)

| | NaClO$_3$ wt % | HCl wt % | H$_3$PO$_4$ wt % | HNO$_3$ wt % | H$_2$SO$_4$ wt % | Time required for etching |
|---|---|---|---|---|---|---|
| Example 4-17 | 6 | 10 | - | - | - | Fair |
| Example 4-18 | 10 | 7 | - | - | - | Fair |
| Example 4-19 | 10 | 10 | - | - | - | Fair |
| Comp. Ex. 4-16 | 10 | 6 | - | - | - | Poor |
| Comp. Ex. 4-17 | 5 | 10 | - | - | - | Poor |
| Comp. Ex. 4-18 | 10 | - | 10 | - | - | Poor |
| Comp. Ex. 4-19 | 10 | - | - | 10 | - | Poor |
| Comp. Ex. 4-20 | 10 | - | - | - | 10 | Poor |
| Comp. Ex. 4-21 | 10 | - | - | - | - | Poor |

Examples 4-20 to 4-26 and Comparative Example 4-22

The time required for etching was determined by the same method as in Example 4-1 except that the composition of an etching liquid containing 0.01 to 20 wt % of a permanganic acid compound was as shown in Table 18, and the results are given in Table 18 together with the composition.

(Table 18)

| | Etching liquid composition | Time required for etching |
|---|---|---|
| Example 4-20 | KMnO$_4$ 3.2% | Excellent |

(continued)

|  | Etching liquid composition | Time required for etching |
|---|---|---|
| Example 4-21 | $KMnO_4$ 3.2% $H_2SO_4$ 5.0% | Excellent |
| Example 4-22 | $KMnO_4$ 1.0% $H_2SO_4$ 5.0% | Excellent |
| Example 4-23 | $KMnO_4$ 0.1% $H_2SO_4$ 5.0% | Excellent |
| Example 4-24 | $KMnO_4$ 0.01% $H_2SO_4$ 5.0% | Good |
| Example 4-25 | $KMnO_4$ 0.001% $H_2SO_4$ 5.0% | Fair |
| Example 4-26 | $KMnO_4$ 3.2% Acetic acid 5.0% | Excellent |
| Comp. Ex. 4-22 | $KMnO_4$ 0.0001% $H_2SO_4$ 5.0% | Poor |

Examples 4-27 to 4-29 and Comparative Example 4-23

The time required for etching was determined by the same method as in Example 4-1 except that the composition of an etching liquid containing 3.6 to 20 wt % of chromic anhydride was as the formulation shown in Table 19, and the results are given in Table 19 together with the formulation.

(Table 19)

|  | Etching liquid composition | Time required for etching |
|---|---|---|
| Example 4-27 | $CrO_3$ 20.0% | Excellent |
| Example 4-28 | $CrO_3$ 15.0% | Good |
| Example 4-29 | $CrO_3$ 3,6% | Fair |
| Comp. Ex. 4-23 | $CrO_3$ 1.0% | Poor |

Examples 4-30 to 4-37

The time required for etching was tested using sulfonated polyaniline or polypyrrole instead of the conductive polymer used in Example 4-1, and using various types of oxidizing agent shown in Table 20 as an etching agent. The results thus obtained are given in Table 20. % means wt %.
It was confirmed that nitrosyl chloride, a bromic acid compound, a chloric acid compound, a permanganic acid compound, and a hexavalent chromium compound were good etching agents for sulfonated polyaniline.
The criteria for the time required for etching were the same as in Example 4-1.

(Table 20)

| Example | Oxidizing agent | Sulfonated polyaniline | Polypyrrole |
|---|---|---|---|
| Example 4-30 | $KMnO_4$ 3.2% $H_2SO_4$ 5% | Excellent | Excellent |
| Example 4-31 | $NaClO_3$ 10% HCl 10% | Excellent | Good |
| Example 4-32 | $KBrO_3$ 6% HCl 10% | Excellent | Good |
| Example 4-33 | $KBrO_3$ 6% $H_3PO_4$ 10% | Excellent | Fair |
| Example 4-34 | $KBrO_3$ 6% $HNO_3$ 10% | Excellent | Good |
| Example 4-35 | $KBrO_3$ 6% $H_2SO_4$ 10% | Excellent | Good |
| Example 4-36 | HCl 16.1% $HNO_3$ 32.3% | Excellent | Good |
| Example 4-37 | $CrO_3$ 3.6% | Excellent | Good |

Industrial applicability

In accordance with use of the etching liquid of the present invention, a conductive polymer can easily be applied to a display, etc. where patterning, as typified by a polymer organic EL display, is required.

**Claims**

1. An etching liquid for a conductive polymer selected from the group consisting of

(1) an etching liquid comprising greater than 0.5 wt % but no greater than 70 wt % of $(NH_4)_2Ce(NO_3)_6$ or at least 0.5 wt % but no greater than 30 wt % of $Ce(SO_4)_2$,

(2) an etching liquid comprising greater than 0.5 wt % but no greater than 30 wt % of $(NH_4)_4Ce(SO_4)_4$,

(3) an etching liquid comprising a hypochlorous acid salt aqueous solution having an effective chlorine concentration of at least 0.06 wt % and a pH of greater than 3 but less than 8,

(4) an etching liquid comprising nitrosyl chloride which comprises at least 5 wt % of hydrochloric acid and at least 20 wt % of nitric acid, a (hydrochloric acid concentration + 0.51 x nitric acid concentration) value being no greater than 35 wt %, and a (hydrochloric acid concentration + 0.5 x nitric acid concentration) value being at least 30 wt %,

(5) an etching liquid comprising at least 3 wt % but no greater than 40 wt % of a bromic acid compound and at least 4 wt % of an inorganic acid,

(6) an etching liquid comprising at least 6 wt % but no greater than 40 wt % of a chloric acid compound and at least 7 wt % of a hydrogen halide,

(7) an etching liquid comprising at least 0.001 wt % but no greater than 20 wt % of a permanganic acid compound, and

(8) an etching liquid comprising at least 3 wt % but no greater than 30 wt % of a hexavalent chromium compound.

2. The etching liquid for a conductive polymer according to Claim 1, wherein the etching liquid (1) comprises $(NH_4)_2Ce(NO_3)_6$ and greater than 0.1 wt % but no greater than 70 wt % of nitric acid.

3. The etching liquid for a conductive polymer according to Claim 1, wherein the etching liquid (1) comprises $(NH_4)_2Ce(NO_3)_6$ and greater than 0.1 wt % but no greater than 60 wt % of $HClO_4$.

4. The etching liquid for a conductive polymer according to Claim 1, wherein the etching liquid (1) comprises $Ce(SO_4)_2$ and greater than 0.1 wt % but no greater than 70 wt % of nitric acid.

5. The etching liquid for a conductive polymer according to Claim 1, wherein the etching liquid (1) comprises $Ce(SO_4)_2$ and greater than 0.1 wt % but no greater than 40 wt % of sulfuric acid.

6. The etching liquid for a conductive polymer according to Claim 1, wherein the etching liquid (2) comprises greater than 1 wt % but no greater than 40 wt % of sulfuric acid.

7. The etching liquid for a conductive polymer according to Claim 1, wherein in the etching liquid (3), the hypochlorous acid salt aqueous solution is a hypochlorous acid alkali metal salt aqueous solution.

8. The etching liquid for a conductive polymer according to Claim 1, wherein the etching liquid (7) comprises 1 to 50 wt % of an acid.

9. The etching liquid for a conductive polymer according to any one of Claims 1 to 8, wherein the conductive polymer is a polyacetylene, a polyparaphenylene, a poly(paraphenylene vinylene), a polyphenylene, a poly(thienylene vinylene), a polyfluorene, a polyacene, a polyaniline, a polypyrrole, or a polythiophene.

10. The etching liquid for a conductive polymer according to any one of Claims 1 to 8, wherein the conductive polymer is a polyaniline, a polypyrrole, or a polythiophene.

11. The etching liquid for a conductive polymer according to any one of Claims 1 to 8, wherein the conductive polymer is a polyaniline or a polythiophene.

12. The etching liquid for a conductive polymer according to any one of Claims 1 to 8, wherein the conductive polymer is poly(3,4-ethylenedioxythiophene).

13. A method for patterning a conductive polymer employing the etching liquid for a conductive polymer according to any one of Claims 1 to 8.

# *FIG.1*

## INTERNATIONAL SEARCH REPORT

| | International application No. |
|---|---|
| | PCT/JP2007/067806 |

A. CLASSIFICATION OF SUBJECT MATTER
*H01B13/00*(2006.01)i, *C08J7/00*(2006.01)i, *H01L21/306*(2006.01)i

According to International Patent Classification (IPC) or to both national classification and IPC

B. FIELDS SEARCHED

Minimum documentation searched (classification system followed by classification symbols)
H01B13/00, C08J7/00, H01L21/306

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 11-001781 A (Advanced Display Inc.), 06 January, 1999 (06.01.99), Full text (Family: none) | 1-3,9-13 |
| Y | JP 7-072806 A (Sumitomo Chemical Co., Ltd.), 17 March, 1995 (17.03.95), Par. No. [0015] (Family: none) | 1,4,5,9-13 |
| Y A | JP 5-335718 A (NEC Corp.), 17 December, 1993 (17.12.93), Par. No. [0013] (Family: none) | 1-5,7,9-13 6,8 |

☒ Further documents are listed in the continuation of Box C.  ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 21 November, 2007 (21.11.07) | 04 December, 2007 (04.12.07) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

| International application No. |
| PCT/JP2007/067806 |

C (Continuation). DOCUMENTS CONSIDERED TO BE RELEVANT

| Category* | Citation of document, with indication, where appropriate, of the relevant passages | Relevant to claim No. |
|---|---|---|
| Y<br>A | JP 2002-009288 A (Mitsubishi Electric Corp.),<br>11 January, 2002 (11.01.02),<br>Par. No. [0047]<br>(Family: none) | 1,9-13<br>6 |
| Y<br>A | JP 6-021157 A (Sumitomo Metal Mining Co., Ltd.),<br>28 January, 1994 (28.01.94),<br>Par. Nos. [0011] to [0015]<br>(Family: none) | 1,7,9-13<br>8 |
| Y | JP 2-135619 A (Asahi Glass Co., Ltd.),<br>24 May, 1990 (24.05.90),<br>Full text<br>(Family: none) | 1,9-13 |
| Y | JP 2003-183652 A (Alps Electric Co., Ltd.),<br>03 July, 2003 (03.07.03),<br>Full text<br>(Family: none) | 1,9-13 |
| Y | JP 4-212498 A (Canon Inc.),<br>04 August, 1992 (04.08.92),<br>Par. No. [0064]<br>(Family: none) | 1,9-13 |
| Y | JP 2006-224517 A (JSR Corp.),<br>31 August, 2006 (31.08.06),<br>Full text<br>(Family: none) | 12 |
| Y | JP 2004-303940 A (Matsushita Electric<br>Industrial Co., Ltd.),<br>28 October, 2004 (28.10.04),<br>Par. No. [0066]<br>& US 2004/0223270 A1 | 12 |

Form PCT/ISA/210 (continuation of second sheet) (April 2007)

**INTERNATIONAL SEARCH REPORT**

International application No.

PCT/JP2007/067806

| Box No. II Observations where certain claims were found unsearchable (Continuation of item 2 of first sheet) |
|---|

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

| Box No. III Observations where unity of invention is lacking (Continuation of item 3 of first sheet) |
|---|

This International Searching Authority found multiple inventions in this international application, as follows:

```
    Claim 1 sets forth alternative eight groups of etching liquids, but there
is no property or activity common to all the etching liquids.  It is also
clear that there is no characteristic structure common to all the etching
liquids.  Consequently, the eight groups of etching liquids set forth in
claim 1 are not considered to have the same or corresponding special technical
feature.
    It is therefore considered that claim 1 defines eight inventions.
```

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**    ☐ The additional search fees were accompanied by the applicant's protest and, where applicable,
the                              payment of a protest fee.

                        ☐ The additional search fees were accompanied by the applicant's protest but the applicable protest
                             fee was not paid within the time limit specified in the invitation.

Form PCT/ISA/210 (continuation of first sheet (2)) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005109435 A
- JP 5335718 A
- WO 9718944 A